# EUROPEAN PATENT APPLICATION

(11) **EP 4 765 123 A2**
(43) Date of publication of application: **24.06.2026**
(21) Application number: 25225893.4
(22) Date of filing: 19.12.2025
(51) Int. Cl.: G11C 5/04, G11C 7/10, G06F 13/42, G11C 16/10, G11C 16/26, G11C 29/02

(54) **MEMORY SYSTEMS FOR REDUCING SIGNAL LINE LOADS AND OCCUPIED AREAS**

(30) Priority: 23.12.2024 KR 20240194716
(71) Applicant: Samsung Electronics Co., Ltd., Suwon-si, Gyeonggi-do 16677 (KR)
(72) Inventor: KANG, Hyunsuk, 16677 Suwon-si (KR); BYUN, Jindo, 16677 Suwon-si (KR); KANG, Kyoungtae, 16677 Suwon-si (KR); KIM, Sangyun, 16677 Suwon-si (KR); CHOI, Youngdon, 16677 Suwon-si (KR)
(74) Representative: Marks & Clerk LLP

(57) **Abstract**

A memory system for reducing signal line loads and an occupied area includes a controller device and a memory device connected to each other through a plurality of channels. The memory device includes a plurality of first memory chips and a plurality of second memory chips connected to each of the plurality of channels. The controller device provides lower write data to the plurality of first memory chips and upper write data to the plurality of second memory chips. The controller device outputs a data strobe signal and a complementary data strobe signal synchronized with the lower write data and the upper write data to the memory device through clock signal lines commonly connected to the plurality of first memory chips and the plurality of second memory chips.

## Description

### BACKGROUND

System on Chips (SOCs) or application processors (APs) included in electronic devices are evolving into complex forms, and their clock frequencies are also increasing. Additionally, the amount of data that electronic devices or systems may process is increasing. In line with this trend, providing large-capacity memory systems is becoming an important factor in design competition for SOCs and other products.

### SUMMARY

Implementations according to the present disclosure provides memory systems for reducing signal line loads and occupied area.

In general, in some aspects, the present disclosure provides a memory system including a controller device connected to a plurality of channels, and a memory device including a plurality of memory chips connected to the controller device through the plurality of channels, wherein the memory device includes a plurality of first memory chips and a plurality of second memory chips connected to each of the plurality of channels, and first data lines connected to the plurality of first memory chips, second data lines connected to the plurality of second memory chips, and clock signal lines commonly connected to the plurality of first memory chips and the plurality of second memory chips, between each of the plurality of channels and the controller device.

In general, in some aspects, the present disclosure provides a memory system including a controller device connected to a plurality of channels, and a memory device including a plurality of memory chips connected to the controller device through the plurality of channels, wherein the memory device includes a plurality of first memory chips and a plurality of second memory chips connected to each of the plurality of channels, and first command address lines connected to the plurality of first memory chips, second command address lines connected to the plurality of second memory chips, and a command address clock signal line connected commonly to the plurality of first memory chips and the plurality of second memory chips, between each of the plurality of channels and the controller device.

In general, in some aspects, the present disclosure provides a method of operating a memory system including a controller device and a memory device connected to each other through a plurality of channels, the memory device including a plurality of first memory chips and a plurality of second memory chips connected to each of the plurality of channels, wherein the method includes outputting, by the controller device, write data to the memory device through first data lines and second data lines of each of the plurality of channels, wherein lower write data of the write data is provided to the plurality of first memory chips through the first data lines, and upper write data of the write data is provided to the plurality of second memory chips through the second data lines, and outputting, by the controller device, a data strobe signal and a complementary data strobe signal synchronized with the lower write data and the upper write data to the memory device through clock signal lines of each of the plurality of channels, and wherein the clock signal lines are commonly connected to the controller device, and the plurality of first memory chips and the plurality of second memory chips.

In general, in some aspects, the present disclosure provides a method of operating a memory system including a controller device and a memory device connected to each other through a plurality of channels, the memory device including a plurality of first memory chips and a plurality of second memory chips connected to each of the plurality of channels, wherein the method includes outputting, by the controller device, a first command address signal and a second command address signal to the memory device through first command address lines and second command address lines of each of the plurality of channels, wherein the first command address signal is provided to the plurality of first memory chips through the first command address lines, and the second command address signal is provided to the plurality of second memory chips through the second command address lines, and outputting, by the controller device, a command address clock signal synchronized with the first command address signal and the second command address signal to the memory device through a command address clock signal line of each of the plurality of channels, and wherein the command address clock signal line is commonly connected to the controller device, and the plurality of first memory chips and the plurality of second memory chips. In some implementations, a data strobe signal and a complementary data strobe signal are output from a first memory chip of the plurality of first memory chips that outputs the lower read data. In some implementations, the data strobe signal and the complementary data strobe signal are output from a second memory chip of the plurality of second memory chips that outputs the upper read data. In some implementations, the controller device is configured to perform, using a training circuit, a read training operation to determine whether the lower read data and the upper read data were correctly captured by the controller device at a rising edge and a falling edge of the data strobe signal. In some implementations, the memory device is implemented as a multi-chip package in which the plurality of first memory chips and the plurality of second memory chips are mounted in one package.

In general, in some aspects, the present disclosure provides a method of operating a memory system including a controller device and a memory device connected to each other through a plurality of channels, the memory device including a plurality of first memory chips and a plurality of second memory chips connected to each of the plurality of channels, wherein the method includes outputting, by the controller device, write data to the memory device through first data lines and second data lines of each of the plurality of channels, wherein lower write data of the write data is provided to the plurality of first memory chips through the first data lines, and upper write data of the write data is provided to the plurality of second memory chips through the second data lines, and outputting, by the controller device, a data strobe signal and a complementary data strobe signal synchronized with the lower write data and the upper write data to the memory device through clock signal lines of each of the plurality of channels, wherein the clock signal lines are commonly connected to the controller device, and the plurality of first memory chips and the plurality of second memory chips. In some implementations, the method further includes outputting, by the controller device, a read enable signal and a complementary read enable signal to the memory device through the clock signal lines of each of the plurality of channels, outputting, by the memory device, read data to the controller device through the first data lines and the second data lines of each of the plurality of channels, wherein lower read data of the read data is provided to the controller device through the first data lines, and upper read data of the read data is provided to the controller device through the second data lines, and outputting, by the memory device, the data strobe signal and the complementary data strobe signal synchronized with the read data to the controller device through the clock signal lines of each of the plurality of channels, wherein the data strobe signal and the complementary data strobe signal are output from one of the plurality of first memory chips and the plurality of second memory chips. In some implementations, the data strobe signal and the complementary data strobe signal are output from a first memory chip of the plurality of first memory chips that outputs the lower read data. In some implementations, the data strobe signal and the complementary data strobe signal are output from a second memory chip of the plurality of second memory chips that outputs the upper read data. In some implementations, the method further includes providing, by the controller device, a first command address signal and a first command address clock signal to the plurality of first memory chips through first command address lines and first command address clock signal lines of each of the plurality of channels, and providing, by the controller device, a second command address signal and a second command address clock signal to the plurality of second memory chips through second command address lines and second command address clock signal lines of each of the plurality of channels.

In general, in some aspects, the present disclosure provides a method of operating a memory system including a controller device and a memory device connected to each other through a plurality of channels, the memory device including a plurality of first memory chips and a plurality of second memory chips connected to each of the plurality of channels, wherein the method includes outputting, by the controller device, a first command address signal and a second command address signal to the memory device through first command address lines and second command address lines of each of the plurality of channels, wherein the first command address signal is provided to the plurality of first memory chips through the first command address lines, and the second command address signal is provided to the plurality of second memory chips through the second command address lines, and outputting, by the controller device, a command address clock signal synchronized with the first command address signal and the second command address signal to the memory device through a command address clock signal line of each of the plurality of channels, wherein the command address clock signal line is commonly connected to the controller device, and the plurality of first memory chips and the plurality of second memory chips. In some implementations, the method further includes outputting, by the controller device, write data to the memory device through first data lines and second data lines of each of the plurality of channels, wherein lower write data of the write data is provided to the plurality of first memory chips through the first data lines, and upper write data of the write data is provided to the plurality of second memory chips through the second data lines, and outputting, by the controller device, a data strobe signal and a complementary data strobe signal synchronized with the lower write data and the upper write data to the memory device through clock signal lines of each of the plurality of channels, wherein the clock signal lines are commonly connected to the controller device, and the plurality of first memory chips and the plurality of second memory chips. In some implementations, the method further includes outputting, by the controller device, a read enable signal and a complementary read enable signal to the memory device through the clock signal lines of each of the plurality of channels, outputting, by the memory device, read data to the controller device through the first data lines and the second data lines of each of the plurality of channels, wherein lower read data of the read data is provided to the controller device through the first data lines, and upper read data of the read data is provided to the controller device through the second data lines, and outputting, by the memory device, the data strobe signal and the complementary data strobe signal synchronized with the read data to the controller device through the clock signal lines of each of the plurality of channels, wherein the data strobe signal and the complementary data strobe signal output from each of the plurality of channels are output from one of the plurality of first memory chips and the plurality of second memory chips.

At least some of the above and other features of the invention are set out in the claims.

### BRIEF DESCRIPTION OF THE DRAWINGS

FIG. 1 is a diagram of an example of a memory module implementing an example of a memory system.
FIGS. 2 and 3 are block diagrams of the memory system of FIG. 1.
FIG. 4 is a block diagram of an example of a memory system.
FIGS. 5 and 6 are diagrams illustrating an example of a write operation for non-volatile memory chips of a first channel in the memory system of FIG. 4.
FIGS. 7 and 8 are diagrams illustrating an example of a read operation for non-volatile memory chips of the first channel in the memory system of FIG. 4.
FIG. 9 is a block diagram of an example of a memory system.
FIG. 10 is a block diagram of an example of a memory system.
FIG. 11 is a cross-sectional view of an example of a memory device having a B-VNAND structure.
FIG. 12 is a block diagram of an example of a SSD system to which a memory device is applied.
FIG. 13 is a block diagram of a system for describing an example of an electronic device including an example of a memory device.

### DETAILED DESCRIPTION

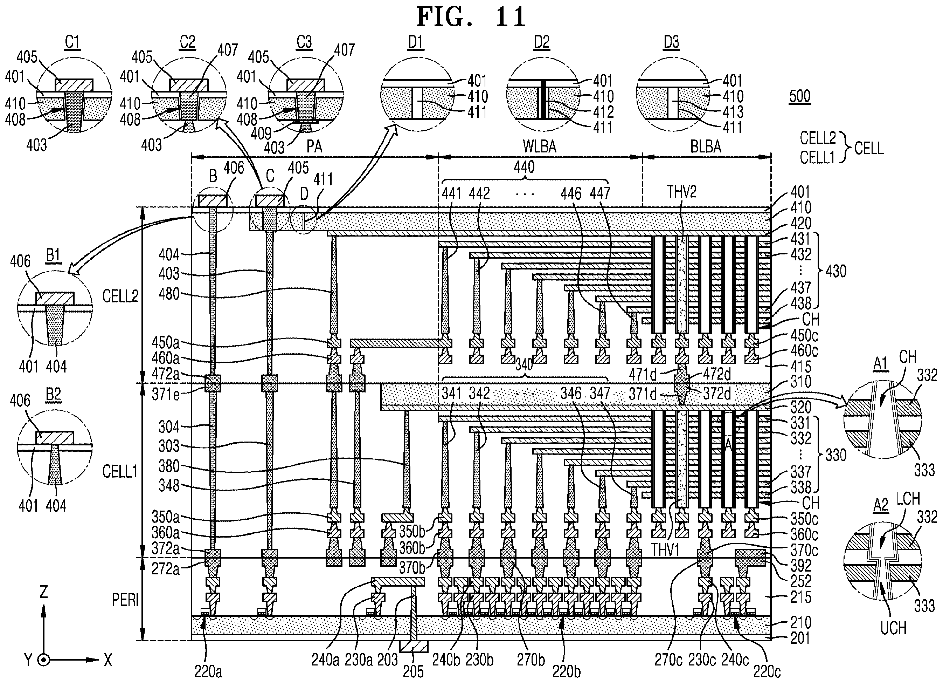

A memory system described herein may include a memory device including memory blocks having a three-dimensional structure. Each of the memory blocks includes NAND flash memory cells, and the memory device may have a chip to chip (C2C) structure. The C2C structure means manufacturing at least one upper chip including a cell area CELL and a lower chip including a peripheral circuit area PERI separately, and then connecting the at least one upper chip to the lower chip by a bonding method. The C2C structure may be implemented to include two upper chips. However, this is only an example. The number of upper chips is not limited thereto. When the memory device is implemented to include two upper chips, as shown in FIG. 11, a first upper chip including a first cell area CELL1, a second upper chip including a second cell area CELL2 may be connected to a lower chip including a peripheral circuit area PERI by a bonding method. Hereinafter, the memory system may include a controller, a plurality of channels connected to the controller, and a first group of memory devices and a second group of memory devices connected to each of the plurality of channels. A plurality of first data signal lines and a plurality of second data signal lines may be connected to the first group of memory devices and the second group of memory devices, respectively, and a plurality of clock signal lines may be commonly connected to the first group of memory devices and to the second group of memory devices. The plurality of first data signal lines and the plurality of second data signal lines are designed to have N/2 (N is a natural number) line loads and the plurality of clock signal lines are designed to have N line loads, thereby reducing the signal line loads and the occupied area in the memory system. For ease of description, the memory device may be interchangeably referred to as a non-volatile memory device.

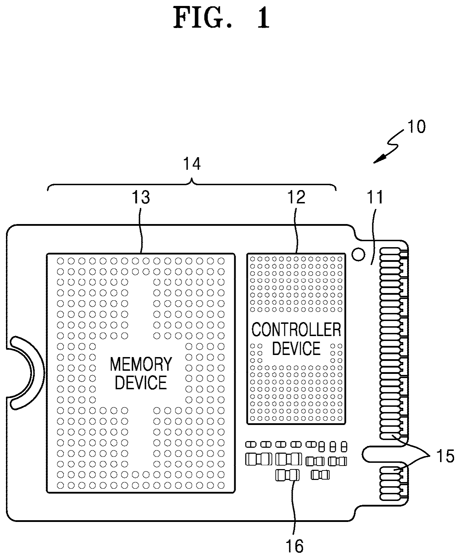

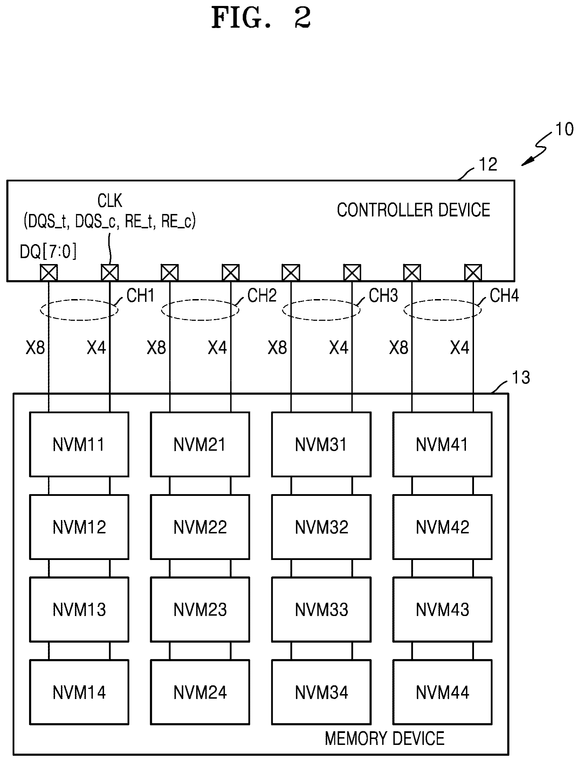

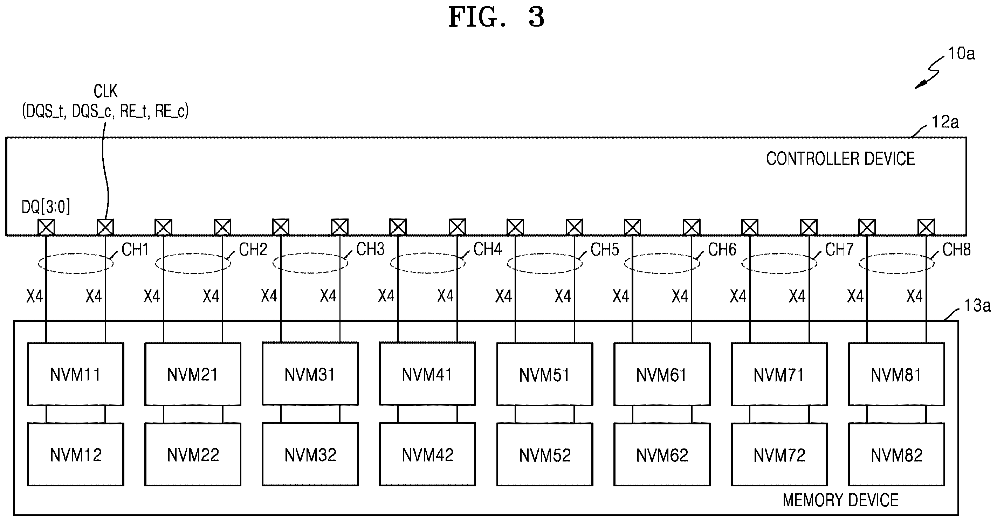

FIGS. 1, 2, and 3 are diagrams of a memory system according to some implementations. FIG. 1 is a diagram of a memory module 10 implementing the memory system, and FIGS. 2 and 3 are block diagrams of the memory system of FIG. 1.

Referring to FIG. 1, the memory module 10 may include a module substrate 11, a controller package 12, a memory package 13, a module connector 14, and a tap pin connector 15. In addition, the memory module 10 may further include passive elements 16 disposed on the module substrate 11. In some implementations, the memory module 10 may include a power management integrated circuit (PMIC) with increased demand for efficient power management and power supply for various functions of the memory module 10. The PMIC may perform a power conversion function and a power sequence function for outputting various output voltages to voltage rails.

The module substrate 11 may include a multilayer circuit substrate having a first surface (or an upper surface) and a second surface (or a lower surface) facing the first surface. For example, the module substrate 11 may include a printed circuit board (PCB) including multiple layers stacked in sequence. The PCB may include wires formed on a surface of the PCB or formed inside the PCB, and vias for connecting the wires to one another. The wires may include a conductive pattern, such as a printed circuit pattern, for interconnecting the controller package 12, the memory package 13, the module connector 14, the tap pin connector 15 and the passive elements 16.

The controller package 12 and the memory package 13 may include a package of a ball grid array (BGA) type and may be disposed on the first surface of the module substrate 11. The module connector 14 may be disposed on the module substrate 11 and may be connected to a system board on which the memory module 10 is mounted. The module connector 14, which is configured as a conductive material, may be disposed on the second surface of the module substrate 11, opposite to the first surface thereof, to which the controller package 12 and the memory package 13 are attached. The passive elements 16 may be disposed on the first surface and/or the second surface of the module substrate 11 and may include an inductor, a capacitor, and a resistor. Hereinafter, for convenience of description, the memory module 10 may be referred to as a memory system 10, the controller package 12 may be referred to as a controller device 12, and the memory package 13 may be referred to as a memory device 13. The subscripts (e.g., a of 10a, b of 10b, and c of 10c) attached to the same reference number in different drawings are intended to distinguish multiple components that have similar or identical functions.

Referring to FIG. 2, the memory system 10 may include the controller device 12 and the memory device 13 and may support a plurality of channels CH1, CH2, CH3, and CH4. The controller device 12 and the memory device 13 may be connected to each other through the plurality of channels CH1 to CH4. The plurality of channels CH1 to CH4 may be implemented in any unit of memory capable of operating according to individual commands from the controller device 12.

The memory device 13 may include a plurality of non-volatile memory chips NVM11, NVM12, NVM13, NVM14, NVM21, NVM22, NVM23, NVM24, NVM31, NVM32, NVM33, NVM34, NVM41, NVM42, NVM43, and NVM44. The memory device 13 may be implemented as a multi-chip package (MCP) on which the non-volatile memory chips NVM11 to NVM44 are mounted in one package. The non-volatile memory chips NVM11 to NVM44 may form a plurality of ways, wherein one of the plurality of ways may be enabled, and non-volatile memory chips corresponding to the enabled way, among the non-volatile memory chips NVM11 and NVM44, may be connected to the plurality of channels CH1 to CH4. The implementation shows a case where a 4-way simultaneous operation (or 4-chip simultaneous operation) is performed. For example, the non-volatile memory chips NVM11, NVM21, NVM31, and NVM41 may communicate with the controller device 12 through the first to fourth channels CH1 to CH4, respectively.

The controller device 12 may transmit and receive signals to and from the memory device 13 through the four channels CH1 to CH4. The controller device 12 may select one of non-volatile memory chips connected to a corresponding channel through each channel and may transmit and receive signals to and from the selected non-volatile memory chip. For example, the controller device 12 may select the non-volatile memory chip NVM11 from among the non-volatile memory chips NVM11, NVM12, NVM13, and NVM14 connected to the first channel CH1, select the non-volatile memory chip NVM21 from among the non-volatile memory chips NVM21, NVM22, NVM23, and NVM24 connected to the second channel CH2, select the non-volatile memory chip NVM31 from among the non-volatile memory chips NVM31, NVM32, NVM33, and NVM34 connected to the third channel CH3, and select the non-volatile memory chip NVM41 from among the non-volatile memory chips NVM41, NVM42, NVM43, and NVM44 connected to the fourth channel CH4. The controller device 12 may transmit commands, addresses, and data through the channels CH1 to CH4 to the selected non-volatile memory chips NVM11, NVM21, NVM31, and NVM41 or receive data from the memory device 13.

Each of the channels CH1 to CH4 may include a plurality of signal lines (or buses) through which signals, based on the NAND interface of the legacy protocol, e.g., DQ[7:0], DQS_t, DQS_c, RE_t, RE_c, CE, CLE, ALE, WE#, are transmitted. The signals RE_t, RE_c, CE, CLE, ALE, and WE# are received by the selected non-volatile memory chips NVM11, NVM21, NVM31, and NVM41, and the signals DQ[7:0], DQS_t, and DQS_c may be transmitted and received between the controller device 12 and the selected non-volatile memory chips NVM11, NVM21, NVM31, and NVM41.

The signal CE includes a signal for enabling the selected non-volatile memory chips NVM11, NVM21, NVM31, and NVM41. The signal CLE includes a signal for informing the selected non-volatile memory chips NVM11, NVM21, NVM31, and NVM41 that the signal DQ[7:0] transmitted to the selected non-volatile memory chips NVM11, NVM21, NVM31, and NVM41 is commands, when the signal CLE is at a logic high level. The signal ALE includes a signal for informing the selected non-volatile memory chips NVM11, NVM21, NVM31, and NVM41 that the signal DQ[7:0] transmitted to the selected non-volatile memory chips NVM11, NVM21, NVM31, and NVM41 is an address, when the signal ALE is at a logic high level. The signal WE# includes a signal for instructing the selected non-volatile memory chips NVM11, NVM21, NVM31, and NVM41 to receive the signal DQ[7:0] transmitted to the selected non-volatile memory chips NVM11, NVM21, NVM31, and NVM41 as write data, when the signal WE# is at a logic low level. The signals RE_t and RE_c include signals for instructing the selected non-volatile memory chips NVM11, NVM21, NVM31, and NVM41 to output the signal DQ[7:0] as read data. The signal DQ[7:0] may include data including the commands, the addresses, and the data transmitted and received between the controller device 12 and the selected non-volatile memory chips NVM11, NVM21, NVM31, and NVM41. The signals DQS_t and DQS_c include signals used for timing the provision of data to the selected non-volatile memory chips NVM11, NVM21, NVM31, and NVM41 with respect to the signal DQ[7:0].

The signals RE_t and RE_c are complementary and the signals DQS_t and DQS_c are complementary. Clock signals are complementary when a rising edge of a first clock signal occurs simultaneously with a falling edge of a second clock signal and when a rising edge of the second clock signal occurs simultaneously with a falling edge of the first clock signal. Hereinafter, for convenience of description, the signals DQS_t, DQS_c, RE_t, and RE_c are referred to as a clock signal (CLK), and the signal DQ[7:0] is referred to as a data signal (DQ). In order to simplify the connection relationship, each of the plurality of channels CH1 to CH4 is represented by eight DQ (x8 DQ) lines and four CLK (x4 CLK) lines.

The memory system 10 includes 16 non-volatile memory chips, where four non-volatile memory chips are connected to each channel, and the DQ lines for each channel have loads of four non-volatile memory chips. The signal DQ[7:0] may have a slow signal setup speed due to loads of the DQ lines. The slow signal setup speed reduces the timing margin of operations (e.g., write and read) of the non-volatile memory chip and degrades the reliability of data. To achieve highspeed operation performance of the memory system 10, it may be needed to reduce the loads of the DQ lines. For example, as shown in FIG. 3, two non-volatile memory chips may be connected to each other for each channel to design a memory system 10a with eight channels CH1 to CH8. Description of the memory system 10a that overlaps with the memory system 10 is omitted.

Referring to FIG. 3, in the memory system 10a, a controller device 12a may transmit and receive signals to and from a memory device 13a through eight channels CH1 to CH8. The memory device 13a may include 16 non-volatile memory chips NVM11, NVM12, NVM21, NVM22, NVM31, NVM32, NVM41, NVM42, NVM51, NVM52, NVM61, NVM62, NVM71, NVM72, NVM81, and NVM82, and each of the channels CH1 to CH8 may include x4 DQ lines and x4 CLK lines. The memory system 10 and the memory system 10a may equally include 16 non-volatile memory chips, and the number of DQ lines may be maintained at 32. However, comparing the memory system 10 with the memory system 10a in the number of CLK lines, the memory system 10 has 16 CLK lines, whereas the memory system 10a has 32 CLK lines, which has 16 more CLK lines than the memory system 10. The memory system 10a, due to the 16 more CLK lines, may increase the occupied area within the memory module 10 (FIG. 1), increase the power consumption, and involve memory module changes. To solve the problem, such as an increase in design cost of the memory system 10a, a memory system for reducing the number of CLK lines may be needed.

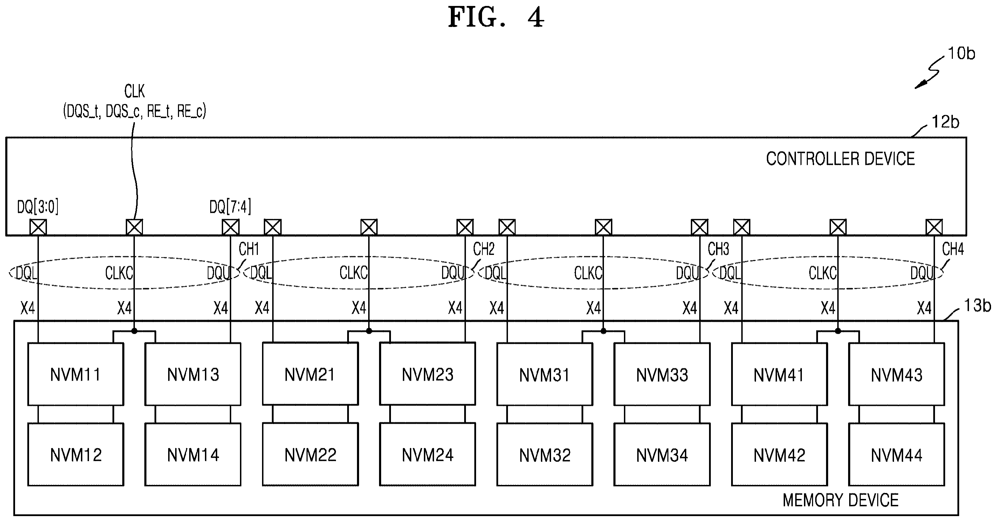

FIG. 4 is a block diagram of a memory system according to some implementations.

Referring to FIG. 4, in a memory system 10b, a controller device 12b may transmit and receive signals to and from a memory device 13b through four channels CH1 to CH4. The controller device 12b may select two non-volatile memory chips (e.g., NVM11 and NVM13) from among the non-volatile memory chips NVM11, NVM12, NVM13, and NVM14 connected to the first channel CH1, select two non-volatile memory chips (e.g., NNM21 and NVM23) from among the non-volatile memory chips NVM21, NVM22, NVM23, and NVM24 connected to the second channel CH2, select two non-volatile memory chips (e.g., NVM31 and NVM33) from among the non-volatile memory chips NVM31, NVM32, NVM33, and NVM34 connected to the third channel CH3, and select two non-volatile memory chips (e.g., NVM41 and NVM43) from among the NVM41, NVM42, NVM43, and NVM44 connected to the fourth channel CH4.

Each of the channels CH1 to CH4 may include a lower DQ line DQL that transmits a signal DQ[3:0], an upper DQ line DQU that transmits a signal DQ[7:4], and a common CLK line CLKC that transmits signals DQS_t, DQS_c, RE_t, and RE_c. In the first channel CH1, the lower DQ line DQL may be connected to the non-volatile memory chips NVM11 and NVM12, the upper DQ line DQU may be connected to the non-volatile memory chips NVM13 and NVM14, and the common CLK line CLKC may be commonly connected to the non-volatile memory chips NVM11, NVM12, NVM13, and NVM 14. In the second channel CH2, the lower DQ line DQL may be connected to the non-volatile memory chips NVM21 and NVM22, the upper DQ line DQU may be connected to the non-volatile memory chips NVM23 and NVM24, and the common CLK line CLKC may be commonly connected to the non-volatile memory chips NVM21, NVM22, NVM23, and NVM 24. In the third channel CH3, the lower DQ line DQL may be connected to the non-volatile memory chips NVM31 and NVM32, the upper DQ line DQU may be connected to the non-volatile memory chips NVM33 and NVM34, and the common CLK line CLKC may be commonly connected to the non-volatile memory chips NVM31, NVM32, NVM33, and NVM 34. In the fourth channel CH4, the lower DQ line DQL may be connected to the non-volatile memory chips NVM41 and NVM42, the upper DQ line DQU may be connected to the non-volatile memory chips NVM43 and NVM44, and the common CLK line CLKC may be commonly connected to the non-volatile memory chips NVM41, NVM42, NVM43, and NVM 44.

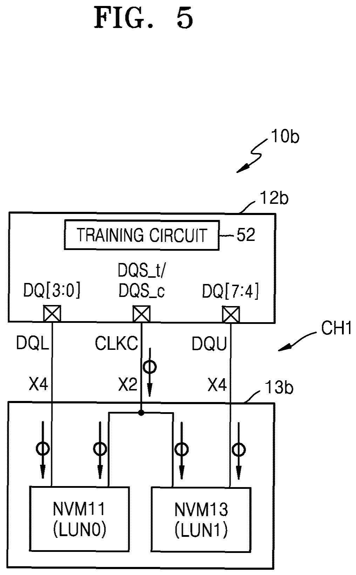

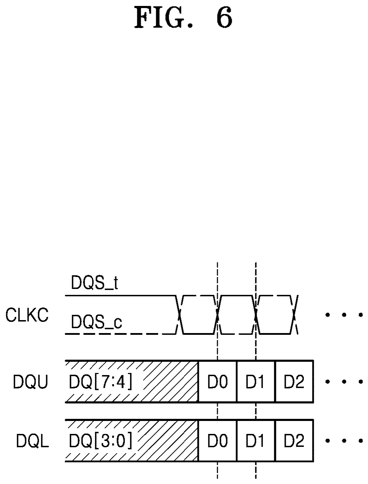

FIGS. 5 and 6 are diagrams illustrating a write operation for the non-volatile memory chips of the first channel CH1 in the memory system 10b of FIG. 4.

Referring to FIGS. 4 and 5, the write operation for the first non-volatile memory chip NVM11 connected to the lower DQ line DQL and the second non-volatile memory chip NVM13 connected to the upper DQ line DQU, among the non-volatile memory chips NVM11, NVM12, NVM13, and NVM14 of the first channel CH1, are shown. The controller device 12b may issue a write command followed by a LUNO address to the first non-volatile memory chip NVM11 through the lower DQ line DQL and issue a write command followed by a LUN1 address to the second non-volatile memory chip NVM13 through the upper DQ line DQU. The LUNO address may include an address specifying the first non-volatile memory chip NVM11, and the LUN1 address may include an address specifying the second non-volatile memory chip NVM13.

Then, the controller device 12b may transmit the data strobe signal DQS_t and the complementary data strobe signal DQS_c to the first non-volatile memory chip NVM11 and the second non-volatile memory chip NVM13 through the common CLK line CLKC. The controller device 12b may transmit the lower write data DQ[3:0] and the upper write data DQ [7:4] together with the data strobe signal DQS_t and the complementary data strobe signal DQS_c to the first non-volatile memory chip NVM11 and the second non-volatile memory chip NVM13.

It is important for the first non-volatile memory chip NVM11 and the second non-volatile memory chip NVM13 to accurately capture the lower write data DQ[3:0] and the upper write data DQ [7:4], according to the transmitted data strobe signal DQS_t and complementary data strobe signal DQS_c. To this end, as shown in FIG. 6, the controller device 12b may use the training circuit 52 to perform a write training operation of determining whether the lower write data DQ[3:0] and the upper write data DQ [7:4] transmitted through the lower DQ line DQL and the upper DQ line DQU at the rising edge and the falling edge of the data strobe signal DQS_t are correctly captured by the first non-volatile memory chip NVM11 and the second non-volatile memory chip NVM13.

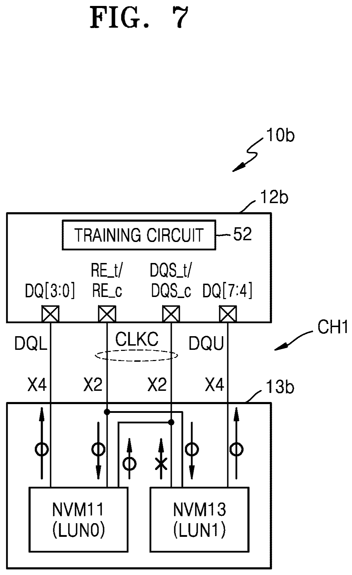

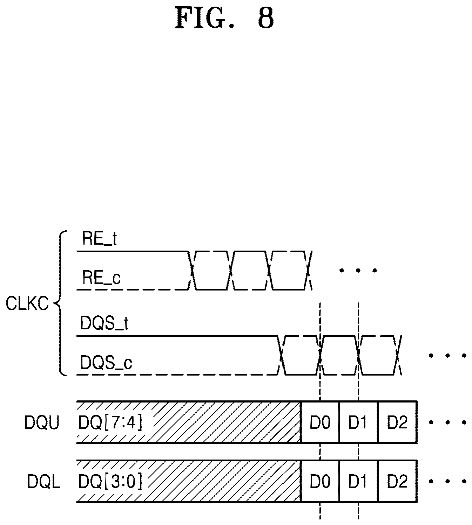

FIGS. 7 and 8 are diagrams illustrating a read operation for the non-volatile memory chips of the first channel CH1 in the memory system 10b of FIG. 4.

Referring to FIGS. 4 and 7, the read operation for the first non-volatile memory chip NVM11 connected to the lower DQ line DQL and the second non-volatile memory chip NVM13 connected to the upper DQ line DQU, among the non-volatile memory chips NVM11, NVM12, NVM13, and NVM14 of the first channel CH1, are shown. The controller device 12b may issue a read command followed by the LUNO address to the first non-volatile memory chip NVM11 through the lower DQ line DQL and issue a read command followed by the LUN1 address to the second non-volatile memory chip NVM13 through the upper DQ line DQU. Each of the first non-volatile memory chip NVM11 and the second non-volatile memory chip NVM13 may perform a read operation according to the read command.

Then, the controller device 12b may transmit the read enable signal RE_t and the complementary enable signal RE_c to the first non-volatile memory chip NVM11 and the second non-volatile memory chip NVM13 through the common CLK line CLKC. The first non-volatile memory chip NVM11 and the second non-volatile memory chip NVM13 may output the read data through the lower DQ line DQL and the upper DQ line DQU according to the data strobe signal DQS_t and the complementary data strobe signal DQS_c.

The data strobe signal DQS_t and the complementary data strobe signal DQS_c may be output from a specified one of the first non-volatile memory chip NVM11 and the second non-volatile memory chip NVM13 and provided to the controller device 12b through the common CLK line CLKC. In this implementation, the data strobe signal DQS_t and the complementary data strobe signal DQS_c output from the first non-volatile memory chip NVM11 selected by the LUNO address specified as the lower one of the LUNO address and the LUN1 address may be provided to the common CLK line CLKC. The second non-volatile memory chip NVM13 may be designed not to output the data strobe signal DQS_t and the complementary data strobe signal DQS_c. This is to prevent collision with the data strobe signal DQS_t and the complementary data strobe signal DQS_c of the first non-volatile memory chip NVM11 provided to the common CLK line CLKC.

The lower read data DQ[3:0] of the first non-volatile memory chip NVM11 may be transmitted to the controller device 12b through the lower DQ line DQL, and the upper read data DQ [7:4] of the second non-volatile memory chip NVM13 may be transmitted to a controller device 12b through the upper DQ line DQU, according to the data strobe signal DQS_t and the complementary data strobe signal DQS_c output from the first non-volatile memory chip NVM11. That is, the memory device 13b may provide the data strobe signal DQS_t and the complementary data strobe signal DQS_c synchronized with the lower read data DQ[3:0] from the first non-volatile memory chip NVM11 that outputs the lower read data DQ[3:0] to the controller device 12b.

In some implementations, the memory device 13b may provide the data strobe signal DQS_t and the complementary data strobe signal DQS_c synchronized with the upper read data DQ[7:4] from the second non-volatile memory chip NVM13 that outputs the upper read data DQ[7:4] to the controller device 12b.

It is important for the first non-volatile memory chip NVM11 and the second non-volatile memory chip NVM13 to accurately output the lower read data DQ[3:0] and the upper read data DQ [7:4] according to the data strobe signal DQS_t and the complementary data strobe signal DQS_c. To this end, as shown in FIG. 8, the controller device 12b may use the training circuit 52 to perform a read data training operation of determining whether the lower read data DQ[3:0] and the upper read data DQ [7:4] transmitted through the lower DQ line DQL and the upper DQ line DQU are correctly captured by the controller device 12a at the rising edge and the falling edge of the data strobe signal DQS_t. The write training operation and the read training operation performed using the training circuit 52 may sequentially and repeatedly perform an operation of adjusting, changing, or correcting code by control of a training program, and the like.

With respect to the memory system 10b described above, the signal line loads and occupied area in the memory system 10b may be reduced through the common CLK line CLKC connected to the non-volatile memory chips connected to the lower DQ line DQL and the non-volatile memory chips connected to the upper DQ line DQU in each of the plurality of channels. Accordingly, the performance of the memory system 10b may be improved and power consumption may be reduced.

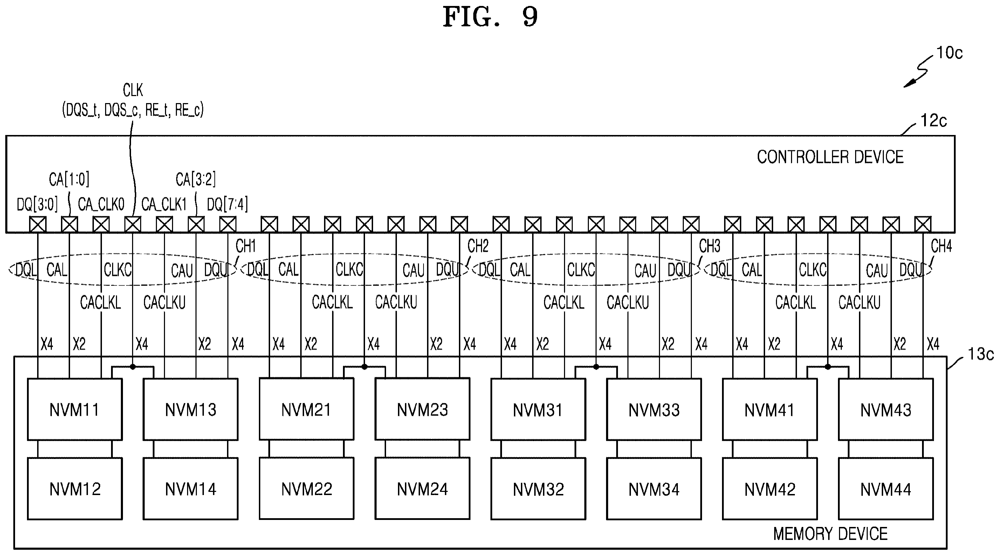

FIG. 9 is a block diagram of a memory system according to some implementations. A memory system 10c of FIG. 9 is different from the memory system 10b of FIG. 4 in that the memory system 10c further includes signal lines CAL, CAU, CACLKL, and CACLKU for transmitting command address signals CA[1:0] and CA[3:2] and command address clock signals CA_CLK0 and CA_CLK1 in each of the channels CH1 to CH4. The command address signal CA[1:0] may be provided from the controller device 12c to the memory device 13c according to the command address clock signal CA_CLK0, and the command address signal CA [3:2] may be provided from the controller devices 12c to the memory device 13c according to a command address clock signal CA_CLK1.

Referring to FIG. 9, the memory system 10c may support a separate command address (SCA) protocol. Compared to the legacy protocol of FIG. 2, the SCA protocol separates command/address (CA) and data (DQ) buses to improve NAND interface effectiveness. For ease of description, the command address signal CA[1:0] is referred to as a lower CA signal, and the command address signal CA[3:2] is referred to as an upper CA signal. Description of the memory system 10c that overlaps with memory system 10b is omitted.

In the memory system 10c, the controller device 12c may transmit and receive signals to and from the memory device 13c through four channels CH1 to CH4. Each of the channels CH1 to CH4 may include the lower DQ line DQL for transmitting the signal DQ[3:0], the upper DQ line DQU for transmitting the signal DQ[7:4], the common CLK line CLKC for transmitting signals DQS_t, DQS_c, RE_t, and RE_c, the lower CA line CAL for transmitting the signal CA[1:0], the upper CA line CAU for transmitting the signal CA[3:2], the first CA_CLK line CACLKL for transmitting the signal CA_CLK0, and the second CA_CLK line CACLKU for transmitting the signal CA_CLK1.

In the first channel CH1, the lower DQ line DQL, the lower CA line CAL, and the first CA_CLK line CACLKL may be connected to the non-volatile memory chips NVM11 and NVM12, the upper DQ line DQU, the upper CA line CAU, and the second CA_CLK line CACLKU may be connected to the non-volatile memory chips NVM13 and NVM14, and the common CLK line CLKC may be commonly connected to the non-volatile memory chips NVM11, NVM12, NVM13, and NVM 14.

In the second channel CH2, the lower DQ line DQL, the lower CA line CAL, and the first CA_CLK line CACLKL may be connected to the non-volatile memory chips NVM21 and NVM22, the upper DQ line DQU, the upper CA line CAU, and the second CA_CLK line CACLKU may be connected to the non-volatile memory chips NVM23 and NVM24, and the common CLK line CLKC may be commonly connected to the non-volatile memory chips NVM21, NVM22, NVM23, and NVM 24.

In the third channel CH3, the lower DQ line DQL, the lower CA line CAL, and the first CA_CLK line CACLKL may be connected to the non-volatile memory chips NVM31 and NVM32, the upper DQ line DQU, the upper CA line CAU, and the second CA_CLK line CACLKU may be connected to the non-volatile memory chips NVM33 and NVM34, and the common CLK line CLKC may be commonly connected to the non-volatile memory chips NVM31, NVM32, NVM33, and NVM 34.

In the fourth channel CH4, the lower DQ line DQL, the lower CA line CAL, and the first CA_CLK line CACLKL may be connected to the non-volatile memory chips NVM41 and NVM42, the upper DQ line DQU, the upper CA line CAU, and the second CA_CLK line CACLKU may be connected to the non-volatile memory chips NVM43 and NVM44, and the common CLK line CLKC may be commonly connected to the non-volatile memory chips NVM41, NVM42, NVM43, and NVM 44.

With respect to the memory system 10c described above, the signal line loads and occupied area in the memory system 10c may be reduced through the common CLK line CLKC connected to the non-volatile memory chips connected to the lower DQ line DQL and the non-volatile memory chips connected to the upper DQ line DQU in each of the plurality of channels, thereby improving performance of the memory system 10c and reducing power consumption.

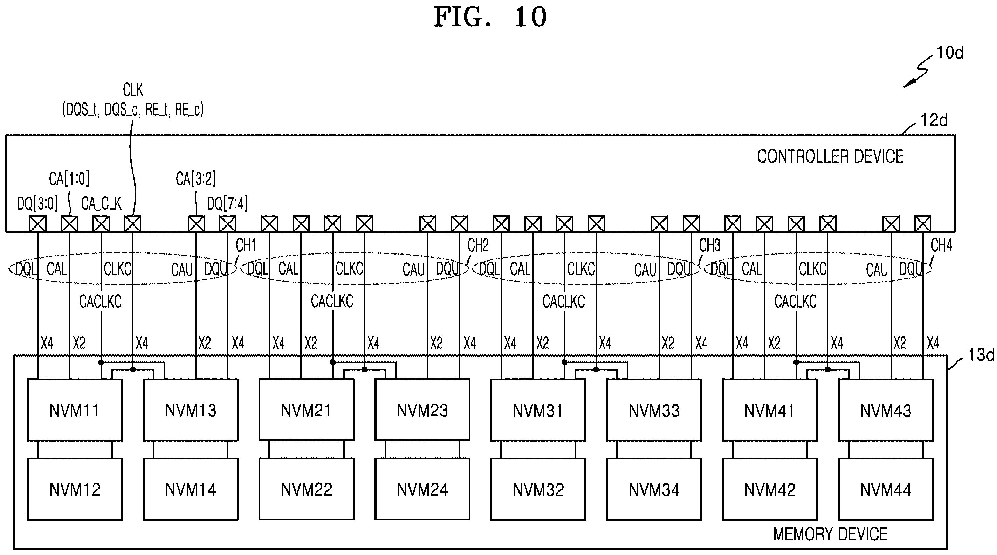

FIG. 10 is a block diagram of a memory system according to some implementations. A memory system 10d of FIG. 10 is different from the memory system 10c of FIG. 9 in that the memory system 10d includes a common CA_CLK line CACLKC that transmits one command address clock signal CA_CLK, instead of the first CA_CLK line CACLKL and the second CA_CLK line CACLKU, in each of the channels CH1 to CH4.

Referring to FIG. 10, in the memory system 10d, the controller device 12d may transmit and receive signals to and from the memory device 13d through four channels CH1 to CH4. Each of the channels CH1 to CH4 may include the lower DQ line DQL for transmitting the signal DQ[3:0], the upper DQ line DQU for transmitting the signal DQ[7:4], the common CLK line CLKC for transmitting signals DQS_t, DQS_c, RE_t, and RE_c, the lower CA line CAL for transmitting the signal CA[1:0], the upper CA line CAU for transmitting the signal CA [3:2], and the common CA_CLK line CACLKC for transmitting the signal CA_CLK.

In the first channel CH1, the lower DQ line DQL and the lower CA line CAL may be connected to the non-volatile memory chips NVM11 and NVM12, the upper DQ line DQU and the upper CA line CAU may be connected to the non-volatile memory chips NVM13 and NVM14, and the common CLK line CLKC and the common CA_CLK line CACLKC may be commonly connected to the non-volatile memory chips NVM11, NVM12, NVM13, and NVM14.

In the second channel CH2, the lower DQ line DQL and the lower CA line CAL may be connected to the non-volatile memory chips NVM21 and NVM22, the upper DQ line DQU and the upper CA line CAU may be connected to the non-volatile memory chips NVM23 and NVM24, and the common CLK line CLKC and the common CA_CLK line CACLKC may be commonly connected to the non-volatile memory chips NVM21, NVM22, NVM23, and NVM24.

In the third channel CH3, the lower DQ line DQL and the lower CA line CAL may be connected to the non-volatile memory chips NVM31 and NVM32, the upper DQ line DQU and the upper CA line CAU may be connected to the non-volatile memory chips NVM33 and NVM34, and the common CLK line CLKC and the common CA_CLK line CACLKC may be commonly connected to the non-volatile memory chips NVM31, NVM32, NVM33, and NVM34.

In the fourth channel CH4, the lower DQ line DQL and the lower CA line CAL may be connected to the non-volatile memory chips NVM41 and NVM42, the upper DQ line DQU and the upper CA line CAU may be connected to the non-volatile memory chips NVM43 and NVM44, and the common CLK line CLKC and the common CA_CLK line CACLKC may be commonly connected to the non-volatile memory chips NVM41, NVM42, NVM43, and NVM44.

In some implementations, the signal CA[1:0] and the signal CA[3:2] may be used to provide state information of non-volatile memory chips (e.g., NVM11 and NVM13) connected to the lower CA line CAL and the upper CA line CAU, respectively.

With respect to the memory system 10d described above, the signal line loads and the occupied area in the memory system 10d may be reduced through the common CLK line CLKC and the common CA_CLK line CACLKC connected to the non-volatile memory chips connected to the lower DQ line DQL and the non-volatile memory chips connected to the upper DQ line DQU in each of the plurality of channels, thereby improving the performance of the memory system 10d and reducing power consumption.

FIG. 11 is a cross-sectional view of a memory device 500 having a B-VNAND structure.

Referring to FIG. 11, the memory device 500 may have a C2C structure. The C2C structure means manufacturing at least one upper chip including a cell area CELL and a lower chip including a peripheral circuit area PERI separately, and then connecting the at least one upper chip to the lower chip by a bonding method. As an example, the bonding method may refer to a method of electrically or physically connecting the bonding metal pattern formed on the top metal layer of the upper chip to the bonding metal pattern formed on the top metal layer of the lower chip. For example, when the bonding metal patterns are formed of copper (Cu), the bonding method may include a Cu_Cu bonding method. As another example, the bonding metal patterns may also be formed of aluminum (Al) or tungsten (W).

The memory device 500 may include at least one upper chip including a cell area. For example, as shown in FIG. 11, the memory device 500 may be implemented to include two upper chips. However, this is an example. The number of upper chips is not limited thereto. When the memory device 500 is implemented to include two upper chips, the memory device 500 may be fabricated by separately fabricating a first upper chip including a first cell area CELL1, a second upper chip including a second cell area CELL2, and a lower chip including a peripheral circuit area PERI, and then connecting the first upper chip, the second upper chip, and the lower chip to each other by a bonding method. The first upper chip may be inverted and bonded to the lower chip, and the second upper chip may also be inverted and bonded to the first upper chip. In the following description, upper and lower portions of the first and second upper chips are defined based on the time before the first upper chip and the second upper chip are inverted. That is, in FIG. 11, the upper portion of the lower chip refers to an upper portion defined with reference to a +Z-axis direction, and the upper portion of each of the first and second upper chips refers to an upper portion defined with reference to a -Z-axis direction. However, this is an example. The first upper chip and the second upper chip may be inverted and connected by a bonding method.

Each of the peripheral circuit area PERI and the first and second cell areas CELL1 and CELL2 of the memory device 500 may include an external pad bonding area PA, a word line bonding area WLBA, and a bit line bonding area BLBA.

The peripheral circuit area PERI may include a first substrate 210 and a plurality of circuit elements 220a, 220b, and 220c formed on the first substrate 210. An interlayer insulating layer 215 including one or more insulating layers may be provided on the plurality of circuit elements 220a, 220b, and 220c, and a plurality of metal wires connecting the plurality of circuit elements 220a, 220b, and 220c to each other may be provided in the interlayer insulating layer 215. For example, the plurality of metal wires may include first metal wires 230a, 230b, and 230c connected to the plurality of circuit elements 220a, 220b, and 220c, respectively, and second metal wires 240a, 240b, and 240c formed on the first metal wires 230a, 230b, and 230c. The plurality of metal wires may include at least one of a variety of conductive materials. For example, the first metal wires 230a, 230b, and 230c may include W having a relatively high electrical resistivity, and the second metal wires 240a, 240b, and 240c may include Cu having a relatively low electrical resistivity.

Although only the first metal wires 230a, 230b, and 230c and the second metal wires 240a, 240b, and 240c are shown and described herein, one or more additional metal wires may be further formed on the second metal wires 240a, 240b, and 240c. In this case, the second metal wires 240a, 240b, and 240c may include Al. In addition, at least some of the additional metal wires formed on the second metal wires 240a, 240b, and 240c may include Cu or the like having a lower electrical resistivity than Al of the second metal wires 240a, 240b, and 240c.

The interlayer insulating layer 215 may be disposed on the first substrate 210 and may include an insulating material, such as silicon oxide, silicon nitride, or the like.

The first and second cell areas CELL1 and CELL2 may each include at least one memory block. The first cell area CELL1 may include a second substrate 310 and a common source line 320. On the second substrate 310, a plurality of word lines 330 (331 to 338) may be stacked in a direction (Z-axis direction) perpendicular to the upper surface of the second substrate 310. String selection lines and a ground selection line may be disposed above and below the word lines 330, and the plurality of word lines 330 may be arranged between the string selection lines and the ground selection line. Similarly, the second cell area CELL2 may include a third substrate 410 and a common source line 420, and a plurality of word lines 430 (431 to 438) may be stacked in a direction (Z-axis direction) perpendicular to the upper surface of the third substrate 410. The second substrate 310 and the third substrate 410 may include various materials, for example, a silicon substrate, a silicon-germanium substrate, a germanium substrate, or a substrate having a monocrystalline epitaxial layer grown on a monocrystalline silicon substrate. A plurality of channel structures CH may be formed in each of the first and second cell areas CELL1 and CELL2.

In some implementations, as shown in A1, a channel structure CH may be provided in the bit line bonding area BLBA and may extend in a direction perpendicular to the upper surface of the second substrate 310 to penetrate the word lines 330, the string selection lines, and the ground selection line. The channel structure CH may include a data storage layer, a channel layer, a buried insulating layer, and the like. The channel layer may be electrically connected to a first metal wire 350c and a second metal wire 360c in the bit line bonding area BLBA. For example, the second metal wire 360c may include a bit line and may be connected to the channel structure CH through the first metal wire 350c. The second metal wire 360c may extend in a first direction (Y-axis direction) parallel to the upper surface of the second substrate 310.

In some implementations, as shown in A2, the channel structure CH may include a lower channel LCH and an upper channel UCH connected to each other. For example, the channel structure CH may be formed through a process for the lower channel LCH and a process for the upper channel UCH. The lower channel LCH may extend in a direction perpendicular to the upper surface of the second substrate 310 to penetrate the common source line 320 and the lower word lines 331 and 332. The lower channel LCH may include a data storage layer, a channel layer, and a buried insulating layer, and may be connected to the upper channel UCH. The upper channel UCH may pass through the upper word lines 333 to 338. The upper channel UCH may include a data storage layer, a channel layer, and a buried insulating layer, wherein the channel layer of the upper channel UCH may be electrically connected to the first metal wire 350c and the second metal wire 360c. As the length of the channel increases, it may become difficult to form a channel with a constant width due to process reasons. The memory device 500, according to some implementations, may include a channel having improved width uniformity implemented through the lower channel LCH and the upper channel UCH formed in a sequential process.

When the channel structure CH is formed to include the lower channel LCH and the upper channel UCH as shown in A2, the word line located near the boundary between the lower channel LCH and the upper channel UCH may include a dummy word line. For example, the word line 332 and the word line 333 that form the boundary between the lower channel LCH and the upper channel UCH may include dummy word lines. In this case, no data may be stored in the memory cells connected to the dummy word lines. Alternatively, the number of pages corresponding to memory cells connected to the dummy word lines may be less than the number of pages corresponding to memory cells connected to general word lines. The voltage level applied to the dummy word lines may be different from the voltage level applied to the general word lines, thereby reducing the impact of the non-uniform channel width between the lower channel LCH and the upper channel UCH on the operation of the memory device 500.

On the other hand, in A2, the number of lower word lines 331 and 332 through which the lower channel LCH passes is shown to be less than the number of upper word lines 333 to 338 through which the upper channel UCH passes. However, this is an example. As another example, the number of lower word lines through which the lower channel LCH passes may be formed to be equal to or greater than the number of upper word lines through which the upper channel UCH passes. In addition, the structure and connection relationship of the channel structure CH arranged in the first cell area CELL1 described above may be equally applied to the channel structure CH arranged in the second cell area CELL2.

In the bit line bonding area BLBA, the first cell area CELL1 may be provided with a first through-hole electrode THV1, and the second cell area CELL2 may be provided with a second through-hole electrode THV2. As shown in FIG. 11, the first through-hole electrode THV1 may penetrate the common source line 320 and the plurality of word lines 330. However, this is an example. The first through-hole electrode THV1 may further penetrate the second substrate 310. The first through-hole electrode THV1 may include a conductive material. Alternatively, the first through-hole electrode THV1 may include a conductive material surrounded by an insulating material. The second through-hole electrode THV2 may also be provided in the same form and structure as the first through-hole electrode THV1.

In some implementations, the first through-hole electrode THV1 and the second through-hole electrode THV2 may be electrically connected to each other through a first through-hole metal pattern 372d and a second through-hole metal pattern 472d. The first through-hole metal pattern 372d may be formed at the bottom of the first upper chip including the first cell area CELL1, and the second through-hole metal pattern 472d may be formed at the top of the second upper chip including the second cell area CELL2. The first through-hole electrode THV1 may be electrically connected to the first metal wire 350c and the second metal wire 360c. A lower via 371d may be formed between the first through-hole electrode THV1 and the first through-hole metal pattern 372d, and an upper via 471d may be formed between the second through-hole electrode THV2 and the second through-hole metal pattern 472d. The first through-hole metal pattern 372d may be connected to the second through-hole metal pattern 472d by a bonding method.

In addition, in the bit line bonding area BLBA, an upper metal pattern 252 may be formed on the top metal layer of the peripheral circuit area PERI, and an upper metal pattern 392 having the same shape as the upper metal pattern 252 may be formed on the top metal layer of the first cell area CELL1. The upper metal pattern 392 of the first cell area CELL1 and the upper metal pattern 252 of the peripheral circuit area PERI may be electrically connected to each other by a bonding method. In the bit line bonding area BLBA, the second metal wire 360c may be electrically connected to a page buffer included in the peripheral circuit area PERI. For example, some of the circuit elements 220c of the peripheral circuit area PERI may provide a page buffer, and the second metal wire 360c may be electrically connected to the circuit elements 220C providing the page buffer through an upper bonding metal 370c of the first cell area CELL1 and an upper bonding metal 270c of the peripheral circuit area PERI.

Referring to FIG. 11, in the word line bonding area WLBA, the word lines 330 of the first cell area CELL1 may extend in a second direction (X-axis direction) parallel to the upper surface of the second substrate 310 and may be connected to a plurality of cell contact plugs 340 (341 to 347). A first metal wire 350b and a second metal wire 360b may be sequentially connected to each other above the cell contact plugs 340 connected to the word lines 330. The cell contact plugs 340 may be connected to the peripheral circuit area PERI through the upper bonding metal 370b of the first cell area CELL1 and the upper bonding metal 270b of the peripheral circuit area PERI in the word line bonding area WLBA.

The cell contact plugs 340 may be electrically connected to a row decoder included in the peripheral circuit area PERI. For example, some of the circuit elements 220b of the peripheral circuit area PERI may provide the row decoder, and the cell contact plugs 340 may be electrically connected to the circuit elements 220b providing the row decoder through the upper bonding metal 370b of the first cell area CELL1 and the upper bonding metal 270b of the peripheral circuit area PERI. In some implementations, the operating voltage of the circuit elements 220b providing the row decoder may be different from the operating voltage of the circuit elements 220c providing the page buffer. For example, the operating voltage of the circuit elements 220c providing the page buffer may be greater than the operating voltage of the circuit elements 220b providing the row decoder.

Similarly, in the word line bonding area WLBA, the word lines 430 of the second cell area CELL2 may extend in the second direction (X-axis direction) parallel to the upper surface of the third substrate 410 and may be connected to a plurality of cell contact plugs 440 (441 to 447). The cell contact plugs 440 may be connected to the peripheral circuit area PERI through the upper metal pattern of the second cell area CELL2, the lower metal pattern and the upper metal pattern of the first cell area CELL1, and the cell contact plug 348.

In the word line bonding area WLBA, the upper bonding metal 370b may be formed in the first cell area CELL1, and the upper bonding metal 270b may be formed in the peripheral circuit area PERI. The upper bonding metal 370b of the first cell area CELL1 and the upper bonding metal 270b of the peripheral circuit area PERI may be electrically connected to each other by a bonding method. The upper bonding metal 370b and the upper bonding metal 270b may include Al, Cu, W, or the like.

In the external pad bonding area PA, a lower metal pattern 371e may be formed at a lower portion of the first cell area CELL1, and an upper metal pattern 472a may be formed at an upper portion of the second cell area CELL2. The lower metal pattern 371e of the first cell area CELL1 and the upper metal pattern 472a of the second cell area CELL2 may be connected to each other by a bonding method, in the external pad bonding area PA. Similarly, an upper metal pattern 372a may be formed in the first cell area CELL1 and an upper metal pattern 272a may be formed in the peripheral circuit area PERI. The upper metal pattern 372a of the first cell area CELL1 and the upper metal pattern 272a of the peripheral circuit area PERI may be connected to each other by a bonding method.

Common source line contact plugs 380 and 480 may be arranged in the external pad bonding area PA. The common source line contact plugs 380 and 480 may include a conductive material, such as a metal, a metal compound, or doped polysilicon. The common source line contact plug 380 of the first cell area CELL1 may be electrically connected to the common source line 320, and the common source line contact plug 480 of the second cell area CELL2 may be electrically connected to the common source line 420. A first metal wire 350a and a second metal wire 360a may be sequentially stacked on the common source line contact plug 380 of the first cell area CELL1, and a first metal wire 450a and a second metal wire 460a may be sequentially stacked on the common source line contact plug 480 of the second cell area CELL2.

First to third input/output (I/O) pads 205, 405, and 406 may be arranged in the external pad bonding area PA. Referring to FIG. 11, a lower insulating film 201 may cover a lower surface of the first substrate 210, wherein the first I/O pad 205 may be formed on the lower insulating film 201. The first I/O pad 205 may be connected to at least one of the plurality of circuit elements 220a arranged in the peripheral circuit area PERI through the first I/O contact plug 203 and may be separated from the first substrate 210 by the lower insulating film 201. In addition, a side insulating film may be arranged between the first I/O contact plug 203 and the first substrate 210 to electrically separate the first I/O contact plug 203 from the first substrate 210.

An upper insulating film 401 covering an upper surface of the third substrate 410 may be formed on the third substrate 410. The second I/O pad 405 and/or the third I/O pad 406 may be disposed on the upper insulating film 401. The second I/O pad 405 may be connected to at least one of the plurality of circuit elements 220a arranged in the peripheral circuit area PERI through the second I/O contact plugs 403 and 303, and the third I/O pad 406 may be connected to the at least one of the plurality of circuit elements 220a arranged in the periphery circuit area PERI through the third I/O contact plugs 404 and 304.

In some implementations, the third substrate 410 may not be arranged in an area without any I/O contact plug. For example, as shown in B, the third I/O contact plug 404 may be separated from the third substrate 410 in a direction parallel to the upper surface of the third substrate 410 and may be connected to the third I/O pad 406 to penetrate the interlayer insulating layer 415 of the second cell area CELL2. In this case, the third I/O contact plug 404 may be formed by various processes.

For example, as shown in B1, the third I/O contact plug 404 may be formed to extend in the third direction (Z-axis direction) and have a diameter which increases toward the upper insulating film 401. That is, the diameter of the channel structure CH described in A1 is formed to decrease toward the upper insulating film 401, whereas the diameter of the third I/O contact plug 404 may be formed to increase toward the upper insulating film 401. For example, the third I/O contact plug 404 may be formed after the second cell area CELL2 is connected to the first cell area CELL1 by a bonding method.

In addition, for example, as shown in B2, the third I/O contact plug 404 may be formed to extend in the third direction (Z-axis direction) and have a diameter which decreases toward the upper insulating film 401. That is, the diameter of the third I/O contact plug 404 may be formed to decrease toward the upper insulating film 401, like the channel structure CH. For example, the third I/O contact plug 404 may be formed with the cell contact plugs 440 before the first cell area CELL1 is bonded to the second cell area CELL2.

In some implementations, the I/O contact plug may overlap with the third substrate 410. For example, as shown in C, the second I/O contact plug 403 may pass through the interlayer insulating layer 415 of the second cell area CELL2 in the third direction (Z-axis direction) and may be electrically connected to the second I/O pad 405 through the third substrate 410. In this case, the connection structure between the second I/O contact plug 403 and the second I/O pad 405 may be implemented in various ways.

For example, as shown in C1, an opening 408 passing through the third substrate 410 may be formed, and the second I/O contact plug 403 may be directly connected to the second I/O pad 405 through the opening 408 formed in the third substrate 410. In this case, as shown in C1, the diameter of the second I/O contact plug 403 may be formed to increase toward the second I/O pad 405. However, this is an example. The diameter of the second I/O contact plug 403 may be formed to decrease toward the second I/O pad 405.

For example, as shown in C2, the opening 408 passing through the third substrate 410 may be formed and a contact 407 may be formed in the opening 408. One end of the contact 407 may be connected to the second I/O pad 405 and the other end of the contact 407 may be connected to the second I/O contact plug 403. Accordingly, the second I/O contact plug 403 may be electrically connected to the second I/O pad 405 through the contact 407 in the opening 408. In this case, as shown in C2, the diameter of the contact 407 may increase toward the second I/O pad 405, and the diameter of the second I/O contact plug 403 may decrease toward the second I/O pad 405. For example, the second I/O contact plug 403 may be formed with the cell contact plugs 440 before the second cell area CELL2 is bonded to the first cell area CELL1, and the contact 407 may be formed after the second cell area CELL2 is bonded to the first cell area CELL1.

In addition, for example, as shown in C3, a stopper 409 may be further formed on the upper surface of the opening 408 of the third substrate 410, compared with C2. The stopper 409 may be a metal wire formed in the same layer as the common source line 420. However, this is an example. The stopper 409 may include a metal wire formed in the same layer as at least one of the word lines 430. The second I/O contact plug 403 may be electrically connected to the second I/O pad 405 through the contact 407 and the stopper 409.

On the other hand, similar to the second and third I/O contact plugs 403 and 404 of the second cell area CELL2, the second and third I/O contact plug 303 and 304 of the first cell area CELL1 may each be formed to have a diameter which decreases toward the lower metal pattern 371e or increases toward the lower metal patterns 371e.

According to some implementations, a slit 411 may be formed in the third substrate 410. For example, the slit 411 may be formed at any location in the external pad bonding area PA. In one example, as shown in D, the slit 411 may be positioned between the second I/O pad 405 and the cell contact plugs 440 in a plan view. However, this is an example. The slit 411 may be formed such that the second I/O pad 405 is located between the slit 411 and the cell contact plugs 440 in a plan view.

For example, as shown in D1, the slit 411 may be formed to penetrate the third substrate 410. For example, the slit 411 may be used to prevent the third substrate 410 from being finely split when forming the opening 408. However, this is an example. The slit 411 may be formed to a depth of about 60% to 70% with respect to the thickness of the third substrate 410.

In addition, for example, as shown in D2, a conductive material 412 may be formed in the slit 411. For example, the conductive material 412 may be used for discharging a leakage current generated during operation of circuit elements in the external pad bonding area PA to the outside. In this case, the conductive material 412 may be connected to an external ground line.

In addition, for example, as shown in D3, an insulating material 413 may be formed in the slit 411. For example, the insulating material 413 may be formed to electrically isolate the second I/O pad 405 and the second I/O contact plug 403 arranged in the external pad bonding area PA from the word line bonding area WLBA. By forming the insulating material 413 in the slit 411, it is possible to prevent the voltage provided through the second I/O pad 405 from affecting the metal layer disposed on the third substrate 410 in the word line bonding area WLBA.

According to some implementations, the first to third I/O pads 205, 405, and 406 may be selectively formed. For example, the memory device 500 may be implemented to include only the first I/O pad 205 disposed on the first substrate 210, or include only the second I/O pad 405 disposed on the third substrate 410, or include only the third I/O pad 406 disposed on the upper insulating film 401.

According to some implementations, at least one of the second substrate 310 of the first cell area CELL1 and the third substrate 410 of the second cell area CELL2 may be used as a sacrificial substrate and may be completely or partially removed before or after the bonding process. An additional film may be deposited after removing the substrate. For example, the second substrate 310 of the first cell area CELL1 may be removed before or after the peripheral circuit area PERI is bonded to the first cell area CELL1, and an insulating film covering the upper surface of the common source line 320 or a conductive film for connection may be formed. Similarly, the third substrate 410 of the second cell area CELL2 may be removed before or after the first cell area CELL1 is bonded to the second cell area CELL2, and the upper insulating film 401 covering the upper surface of the common source line 420 or the conductive film for connection may be formed.

In some implementations, the upper bonding metals 270c of the peripheral circuit area PERI may be arranged on an upper portion of a page buffer circuit area and may be arranged in a matrix form in the first direction (Y-axis direction) and the second direction (X-axis direction). The page buffer circuit area may correspond to the bit line bonding area BLBA. For example, the upper bonding metals 270c may be grouped into a plurality of bonding pad groups, wherein each of the bonding pad groups may include upper bonding metals arranged in a row in the first direction (Y-axis direction). In some implementations, the peripheral circuit area PERI may include a plurality of through wires extending in the first direction (Y-axis direction). For example, each through wire may be arranged between adjacent bonding pad groups.

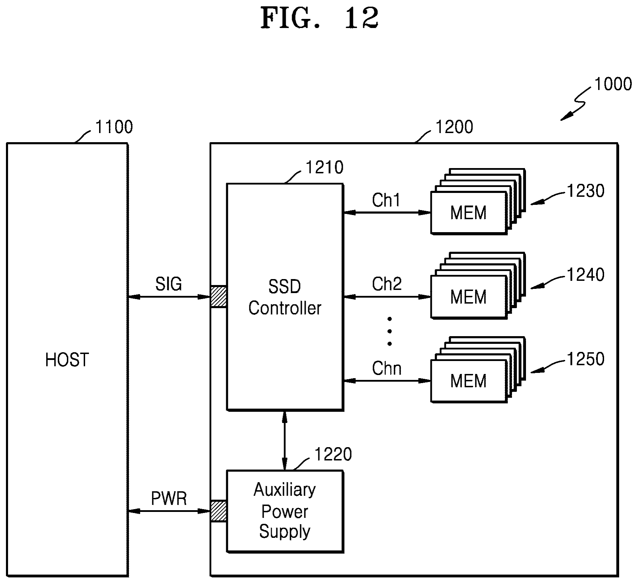

FIG. 12 is a block diagram of an SSD system 1000 to which a memory device is applied, according to some implementations.

Referring to FIG. 12, the SSD system 1000 may include a host 1100 and an SSD 1200. The SSD 1200 transmits and receives signals to and from the host 1100 through a signal connector SIG and receives power through a power connector PWR. The SSD 1200 may include an SSD controller 1210, an auxiliary power supply 1220, and memory devices 1230, 1240, and 1250. The memory devices 1230, 1240, and 1250 may include vertically stacked NAND flash memory devices. The SSD 1200 may be implemented using implementations described above with reference to FIGS. 1 to 11.

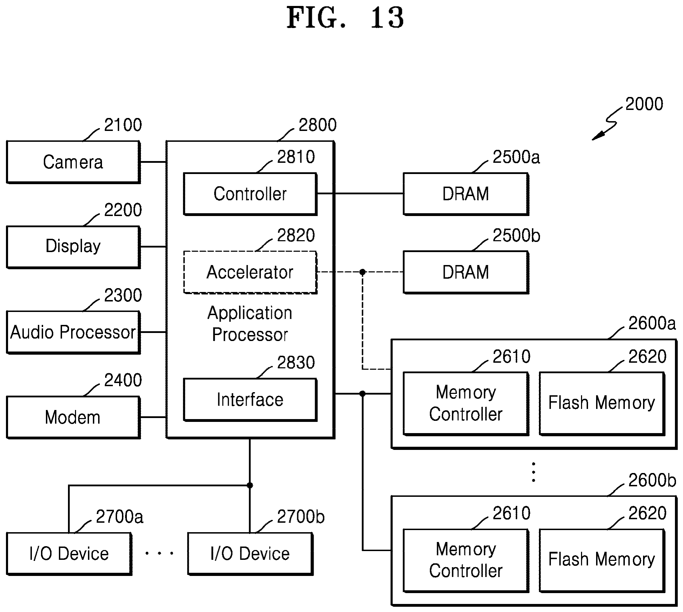

FIG. 13 is a block diagram of a system 2000 for describing an electronic device including a memory device, according to some implementations.

Referring to FIG. 13, the system 2000 may include a camera 2100, a display 2200, an audio processor 2300, a modem 2400, DRAMs 2500a and 2500b, flash memories 2600a and 2600b, I/O devices 2700a and 2700b, and an application processor (AP) 2800. The system 2000 may be implemented as a laptop computer, a mobile phone, a smartphone, a tablet personal computer (PC), a wearable device, a healthcare device, or an Internet Of Things (IOT) device. In addition, the system 2000 may be implemented as a server or a PC.

The camera 2100 may capture an image or a video under the control by a user and may store or transmit the captured image/video data to the display 2200. The audio processor 2300 may process audio data included in the flash memories 2600a and 2600b or content of a network. The modem 2400 may modulate and transmit a signal for wired/wireless data transmission and reception and a receiver may demodulate the signal to restore the same to the original signal. The I/O devices 2700a and 2700b may include devices that provide digital input and/or output functionality, such as a universal serial bus (USB) or storage, a digital camera, a secure digital (SD) card, a digital versatile disc (DVD), a network adapter, a touch screen, and the like.

The AP 2800 may control the overall operation of the system 2000. The AP 2800 may include a controller block 2810, an accelerator block or accelerator chip 2820, and an interface block 2830. The AP 2800 may control the display 2200 such that a part of content stored in the flash memories 2600a and 2600b is displayed on the display 2200. When user input is received through the I/O devices 2700a and 2700b, the AP 2800 may perform the control operation corresponding to the user input. The AP 2800 may include an accelerator block that is a dedicated circuit for artificial intelligence (AI) data operation or may include an accelerator chip 2820 separately from the AP 2800. The DRAM 2500b may be additionally mounted to the accelerator block or accelerator chip 2820. The accelerator, which is a functional block specialized in performing a specific function of the AP 2800, may include a graphics processing unit (GPU) that is a functional block specialized in performing graphics data processing, a neural processing unit (NPU) that is a block specialized in performing AI computation and inference, and a data processing unit (DPU) that is a block specialized in data transmission.

The system 2000 may include a plurality of DRAMs 2500a and 2500b. The AP 2800 may control the DRAMs 2500a and 2500b through commands and mode register (MRS) settings that conform to joint electron device engineering council (JEDEC) standards or may communicate with the DRAMs 2500a and 2500b by setting the DRAM interface protocols to use enterprise-specific functions, such as low voltage/high speed/reliability, and cyclic redundancy check (CRC)/error correction code (ECC) functions. For example, the AP 2800 may communicate with the DRAM 2500a through an interface conforming to the JEDEC standards, such as the LPDDR4 and the LPDDR5, and the accelerator block or the accelerator chip 2820 may communicate with the DRAM 2500a by setting a new DRAM interface protocol to control the DRAM 2500b for accelerators having a higher bandwidth than that of the DRAM 2500a.

FIG. 13 shows only DRAMs 2500a and 2500b but is not limited thereto. Any memory, such as phase-change random-access memory (PRAM), static RAM (SRAM), magneto-resistive RAM (MRAM), resistive RAM (RRAM), ferroelectric RAM (FRAM), or hybrid RAM, may be used as long as the bandwidth, reaction rate, and voltage conditions of the AP 2800 or the accelerator chip 2820 are satisfied. The DRAMs 2500a and 2500b have relatively lower latency and bandwidth than those of the I/O devices 2700a and 2700b or the flash memories 2600a and 2600b. The DRAMs 2500a and 2500b may be initialized when the system 2000 is powered on and may be used as temporary storage locations for the operating system and application data by loading the operating system and application data or as execution spaces for various software codes.

In the DRAMs 2500a and 2500b, addition/subtraction/multiplication/division arithmetic operations and vector operations, address operations, or fast Fourier transform (FFT) operations may be performed. In addition, within the DRAMs 2500a and 2500b, a function for performing inference may be performed. The inference may be performed in a deep learning algorithm using an artificial neural network. The deep learning algorithm may include a training operation of training a model through various data and an inference operation of recognizing data with the trained model. In some implementations, an image captured by a user through the camera 2100 is signal-processed and stored in the DRAM 2500b, and the accelerator block or the accelerator chip 2820 may perform the AI data operation of recognizing data by using the data stored in the DRAM 2500b and the function used for inference.

The system 2000 may include the plurality of flash memories 2600a and 2600b or the plurality of storages having a capacity greater than the DRAMs 2500a and 2500b. The accelerator block or accelerator chip 2820 may perform the training operation and the AI data operation using the flash memories 2600a and 2600b. In some implementations, the flash memories 2600a and 2600b may include a memory controller 2610 and a flash memory device 2620, wherein a computing device provided in the memory controller 2610 may be used to more efficiently perform the inference AI data operation and the training operation performed by the AP 2800 and/or the accelerator chip 2820. The flash memories 2600a and 2600b may store a photograph captured through the camera 2100 or may store data transmitted to a data network. For example, the flash memories 2600a and 2600b may store augmented reality/virtual reality, high definition (HD), or ultra-high definition (UHD) content.

In the system 2000, the flash memories 2600a and 2600b may include the memory system described with reference to FIGS. 1 to 12. The memory system may include a controller device and a memory device connected to each other through a plurality of channels, wherein each of the plurality of channels may include a plurality of first data signal lines and a plurality of second data signal lines connected to a first group of memory chips and a second group of memory chips, respectively, and a plurality of clock signal lines commonly connected to the first group of memory chips and the second group of memory chips. The memory system may include, in each of the plurality of channels, a first command address line and a second command address line connected to the first group of memory chips and the second group of memory chips, respectively, and a command address clock signal line commonly connected to the first group of memory chips and to the second group of memory chips. As the memory system reduces the signal line loads and occupied area, reduces power consumption, and improves the performance, it may be usefully applied to a storage medium, such as a storage device and system.

While this specification contains many specific implementation details, these should not be construed as limitations on the scope of any invention or on the scope of what can be claimed, but rather as descriptions of features that can be specific to particular implementations of particular inventions. Certain features that are described in this specification in the context of separate implementations can also be implemented in combination in a single implementation. Conversely, various features that are described in the context of a single implementation can also be implemented in multiple implementations separately or in any suitable subcombination. Moreover, although features can be described above as acting in certain combinations, one or more features from a combination can in some cases be excised from the combination, and the combination can be directed to a subcombination or variation of a subcombination.

While the inventive concept has been particularly shown and described with reference to implementations thereof, it will be understood that various changes in form and details may be made therein without departing from the scope of the following claims.

## Claims

1. A memory system (10b), comprising:
a controller device (12b) connected to a plurality of channels (CH1, CH2, CH3, CH4); and
a memory device (13b) comprising a plurality of memory chips (NVM11 to NVM44) that are connected to the controller device through the plurality of channels (CH1, CH2, CH3, CH4),
wherein the plurality of memory chips (NVM11 to NVM44) comprise (i) a plurality of first memory chips (NVM11, NVM12) and (ii) a plurality of second memory chips (NVM13, NVM14),
wherein the plurality of the first memory chips (NVM11, NVM12) and the plurality of second memory chips (NVM13, NVM14) are connected to a first channel (CH1) of the plurality of channels (CH1, CH2, CH3, CH4),
wherein the first channel (CH1) comprises (i) a first data signal line (DQL) that is connected to the plurality of first memory chips (NVM11, NVM12) and the controller device (12b) and (ii) a second data signal line (DQU) that is connected to the plurality of second memory chips (NVM13, NVM14) and the controller device (12b), and
wherein the first channel (CH1) further comprises a first clock signal line (CLKC) that is connected to the plurality of first memory chips (NVM11, NVM12), the plurality of second memory chips (NVM13, NVM14), and the controller device (12b).

2. The memory system (10b) of claim 1, wherein the controller device (12b) is configured to:
output, to the memory device (13b), write data (DQ[3:0], DQ[7:4]) through the first data signal line (DQL) and the second data signal line (DQU); and
output, to the memory device (13b), a data strobe signal (DQS_t) and a complementary data strobe signal (DQS_c) synchronized with the write data (DQ[3:0], DQ[7:4]), through the first clock signal line (CLKC).

3. The memory system (10b) of claim 2, wherein the controller device (12b) is configured to:
output, to a first memory chip (NVM11) of the plurality of first memory chips (NVM11, NVM12), lower write data (DQ[3:0]) of the write data (DQ[3:0], DQ[7:4]), through the first data signal line (DQL); and
output, to a second memory chip (NVM13) of the plurality of second memory chips (NVM13, NVM14), upper write data (DQ[7:4]) of the write data (DQ[3:0], DQ[7:4]), through the second data signal line (DQU).

4. The memory system (10b) of claim 3, wherein the controller device (12b) is further configured to perform, using a training circuit (52), a write training operation to determine correct capturing of (i) the lower write data (DQ[3:0]) by the first memory chip (NVM11) at a rising edge of the data strobe signal (DQS_t) and (ii) the upper write data (DQ[7:4]) by the second memory chip (NVM13) at a falling edge of the data strobe signal (DQS_t).

5. The memory system (10b) of any preceding claim, wherein the memory device (13b) is configured to:
receive, from the controller device (12b), a read enable signal (RE_t) and a complementary read enable signal (RE_c), through the first clock signal line (CLKC);
output, to the controller device (12b), read data (DQ[3:0], DQ[7:4]) through the first data signal line (DQL) and the second data signal line (DQU); and
output, to the controller device (12b), a data strobe signal (DQS_t) and a complementary data strobe signal (DQS_c) synchronized with the read data (DQ[3:0], DQ[7:4]), through the first clock signal line (CLKC),
wherein one of the plurality of first memory chips (NVM11, NVM12) and the plurality of second memory chips (NVM13, NVM14) is configured to output, toward the first channel (CH1), the data strobe signal (DQS_t) and the complementary data strobe signal (DQS_c).

6. The memory system (10b) of claim 5, wherein the memory device (13b) is configured to:
output, to the controller device (12b), (i) lower read data (DQ[3:0]) of the read data (DQ[3:0], DQ[7:4]) through the first data signal line (DQL) and (ii) upper read data (DQ[7:4]) of the read data (DQ[3:0], DQ[7:4]), through the second data signal line (DQU).

7. The memory system (10b) of claim 6, wherein a first memory chip (NVM11) of the plurality of first memory chips (NVM11, NVM12) is configured to output (i) the lower read data (DQ[3:0]), (ii) the data strobe signal (DQS_t), and (iii) the complementary data strobe signal (DQS_c).

8. The memory system (10b) of claim 6, wherein a second memory chip (NVM13) of the plurality of second memory chips (NVM13, NVM14) is configured to output (i) the upper read data (DQ[7:4]), (ii) the data strobe signal (DQS_t), and (iii) the complementary data strobe signal (DQS_c).

9. The memory system (10b) of any of claims 6-8, wherein the controller device (12b) is further configured to perform, using a training circuit (52), a read training operation to determine correct capturing of (i) the lower read data (DQ[3:0]) by the controller device (12b) at a rising edge of the data strobe signal (DQS_t) and (ii) the upper read data (DQ[7:4]) by the controller device (12b) at a falling edge of the data strobe signal (DQS_t).

10. The memory system (10b) of any preceding claim, wherein the first channel (CH1) further comprises (i) a first command address line (CAL) and a first command address clock signal line (CACLKL) that are connected to the plurality of first memory chips (NVM11, NVM12) and the controller device (12b), and (ii) a second command address line (CAU) and a second command address clock signal line (CACLKU) that are connected to the plurality of second memory chips (NVM13, NVM14) and the controller device (12b).

11. The memory system (10b) of claim 10, wherein the controller device (12b) is configured to:
output, to the memory device (13c), a first command address signal (CA[1:0]) and a second command address signal (CA[3:2]), through the first command address line (CAL) and the second command address line (CAU) of the first channel (CH1); and
output, to the memory device (13c), (i) a first command address clock signal (CA_CLK0) synchronized with the first command address signal (CA[1:0]), through the first command address clock signal line (CACLKL) of the first channel and (ii) a second command address clock signal (CA_CLK1) synchronized with the second command address signal (CA[3:2]) through the second command address clock signal line (CACLKU).

12. The memory system (10b) of any preceding claim, wherein the plurality of memory chips (NVM11 to NVM44) further comprise:
a plurality of third memory chips (NVM21, NVM22) and a plurality of fourth memory chips (NVM23, NVM24),
wherein the plurality of the third memory chips (NVM21, NVM22) and the plurality of fourth memory chips (NVM23, NVM24) are connected to a second channel (CH2) of the plurality of channels (CH1, CH2, CH3, CH4),
wherein the second channel (CH2) comprises (i) a third data signal line (DQL) that is connected to the plurality of third memory chips (NVM21, NVM22) and the controller device (12b), and (ii) a fourth data signal line (DQU) that is connected to the plurality of fourth memory chips (NVM23, NVM24) and the controller device (12b),
wherein the second channel (CH2) further comprises a second clock signal line (CLKC) that is connected to the plurality of third memory chips (NVM21, NVM22), the plurality of fourth memory chips (NVM23, NVM24), and the controller device (12b), and
wherein the memory device (13c) is implemented as a multi-chip package in which the plurality of first memory chips (NVM11, NVM12), the plurality of second memory chips (NVM13, NVM14), the plurality of third memory chips (NVM21, NVM22), and the plurality of fourth memory chips (NVM23, NVM24) are mounted in one package.

13. A memory system (10c), comprising:
a controller device (12c) connected to a plurality of channels (CH1, CH2, CH3, CH4); and
a memory device (13c) comprising a plurality of memory chips (NVM11 to NVM44) that are connected to the controller device (12c) through the plurality of channels (CH1, CH2, CH3, CH4),
wherein the plurality of memory chips (NVM11 to NVM44) comprises a plurality of first memory chips (NVM11, NVM12) and a plurality of second memory chips (NVM13, NVM14),
wherein the plurality of the first memory chips (NVM11, NVM12) and the plurality of second memory chips (NVM13, NVM14) are connected to a first channel (CH1) of the plurality of channels (CH1, CH2, CH3, CH4),
wherein the first channel (CH1) comprises (i) a first command address line (CAL) that is connected to the plurality of first memory chips (NVM11, NVM12) and the controller device (12c), (ii) a second command address line (CAU) that is connected to the plurality of second memory chips (NVM13, NVM14) and the controller device (12c), and
wherein the first channel (CH1) further comprises a first command address clock signal line (CACLKL) that is connected to the plurality of first memory chips (NVM11, NVM12), the plurality of second memory chips (NVM13, NVM14), and the controller device (12c).

14. The memory system (10c) of claim 13, wherein the controller device (12c) is configured to:
output, to the memory device (13c), a first command address signal (CA[1:0]) and a second command address signal (CA[3:2]), through the first command address line (CAL) and the second command address line (CAU) of the first channel (CH1); and
output, to the memory device (13c), a first command address clock signal (CA_CLK0) synchronized with the first command address signal (CA[1:0]) and the second command address signal (CA[3:2]), through the first command address clock signal line (CACLKL) of the first channel (CH1).

15. The memory system (10c) of claim 13 or claim 14, wherein the first channel (CH1) comprises (i) a first data signal line (DQL) that is connected to the plurality of first memory chips (NVM11, NVM12) and the controller device (12c), (ii) a second data signal line (DQU) that is connected to the plurality of second memory chips (NVM13, NVM14) and the controller device (12c), and (iii) a clock signal line (CLKC) that is connected to the plurality of first memory chips (NVM11, NVM12), the plurality of second memory chips (NVM13, NVM14), and the controller device (12c).
